# EUROPEAN PATENT APPLICATION

(11) **EP 2 416 562 A1**
(43) Date of publication of application: **08.02.2012**
(21) Application number: 10761337.4
(22) Date of filing: 19.03.2010
(51) Int. Cl.: H04N 5/335

(54) **SOLID-STATE IMAGING DEVICE**

(30) Priority: 30.03.2009 JP 2009080930
(71) Applicant: Konica Minolta Opto, Inc., Hachioji-shi Tokyo 192-8505 (JP)
(72) Inventor: MASUDA, Satoshi, Hino-shi Tokyo 191-8511 (JP); KUSUDA, Masayuki, Hino-shi Tokyo 191-8511 (JP)
(74) Representative: HOFFMANN EITLE
(86) International application number: PCT/JP2010/001998
(87) International publication number: WO 2010/116629

(57) **Abstract**

A trace control unit 61 traces photoelectric conversion characteristics of dummy pixels G2 by varying a current value outputted from constant current sources Id. The constant current sources Id are provided common to respective rows in a dummy pixel section 12 and output a current value according to a setting signal outputted from the trace control unit 61. At this point, the trace control unit 61 instructs a vertical scan circuit 2 to turn off a switch ISW during a predetermined read period in which a read circuit 3 reads pixel signals from the dummy pixels G2.

## Description

### Technical Field

The present invention relates to a solid-state imaging device made up of pixels having linear characteristics and logarithmic characteristics.

### Background Art

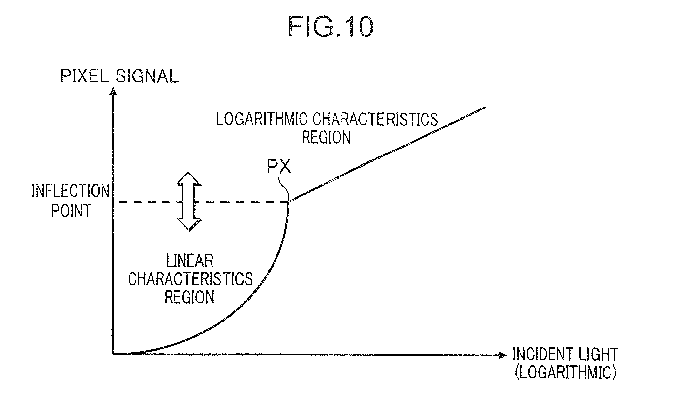

Recently, a solid-state imaging device is known which is made up of pixels having two types of photoelectric conversion characteristics, namely, linear characteristics and logarithmic characteristics. Fig. 10 is a graph showing photoelectric conversion characteristics of a pixel having linear characteristics and logarithmic characteristics. An ordinate represents an output value of a pixel signal read from the pixel, and an abscissa represents a light intensity of light incident to the pixel. Moreover, in the graph shown in Fig. 10, the abscissa is a logarithmic scale.

In the photoelectric conversion characteristics shown in Fig. 10, the output value of the pixel signal increases as the incident light intensity increases, and although the photoelectric conversion characteristics are linear until the incident light intensity exceeds an inflection point PX, the photoelectric conversion characteristics become logarithmic once the incident light intensity exceeds the inflection point PX. Moreover, since the abscissa is represented by a logarithmic scale in Fig. 10, linear characteristics vary in a downward-convex curve while logarithmic characteristics vary in a gentle straight line.

The solid-state imaging device includes an image processing unit which executes various image processing on a pixel signal. The image processing unit may perform image processing by switching among image processing methods depending on a region in which a pixel signal exists, such as performing image processing using image processing parameters for linear characteristics on a pixel signal read in a linear characteristics region and performing image processing using image processing parameters for logarithmic characteristics on a pixel signal read in a logarithmic characteristics region. An example of such image processing is white balance correction.

Here, if a pixel signal output value is greater than an assumed value of the inflection point PX, the image processing unit judges that the pixel signal has been read in the logarithmic characteristics region, and if the pixel signal output value is smaller than the assumed value of the inflection point PX, the image processing unit judges that the pixel signal has been read in the linear characteristics region.

In addition, the inflection point PX is known to vary according to temperature. Therefore, the inflection point PX varies in real time in accordance with a temperature variation during photography.

Consequently, when a value of the inflection point PX recognized by the image processing unit differs from an actual value of the inflection point PX, a situation occurs in which image processing for logarithmic characteristics is used on a pixel signal in the linear characteristics region and image processing for linear characteristics is used on a pixel signal in the logarithmic characteristics region. As a result, a problem arises in that image processing cannot be performed with high accuracy.

In consideration thereof, Patent Document 1 discloses a technique in which, by arranging dummy pixels in respective rows or respective columns of a pixel section and tracing photoelectric conversion characteristics of the dummy pixels while varying a current value supplied to the dummy pixels, temperature characteristics of the photoelectric conversion characteristics are compensated.

In this case, the dummy pixels are configured such that a light-blocking film is formed at an opening to prevent receiving of light, and an electrical charge is accumulated not by receiving light but due to a constant current injected from a constant current source.

Fig. 11 shows a circuit diagram of a dummy pixel according to Patent Document 1. As shown in Fig. 11, the dummy pixel comprises a photodiode PD, a transfer transistor TX, a reset transistor RST, an amplifying transistor SF, a row select transistor SEL, and a floating diffusion FD.

The photodiode PD is shielded from light by a light-blocking film formed at an opening, and a constant current source Id is connected to a cathode. The transfer transistor TX, the reset transistor RST, the amplifying transistor SF and the row select transistor SEL are respectively constituted by, for example, an n-channel MOS (metal oxide semiconductor) transistor and is turned on when a high-level (hereinafter denoted as "Hi") signal is inputted to a gate terminal and turned off when a low-level (hereinafter denoted as "Lo") signal is inputted to the gate terminal.

Specifically, the transfer transistor TX is turned on/off by a signal φTX (hereinafter denoted as "φTX"), the reset transistor RST is turned on/off by a reset signal (hereinafter denoted as "φRST"), and the row select transistor SEL is turned on/off by a row select signal (hereinafter denoted as "φVSEN"). Moreover, AVDD denotes a positive drive voltage and AVSS denotes a negative drive voltage.

The reset transistor RST resets the floating diffusion FD. The transfer transistor TX transfers an electrical charge accumulated by the photodiode PD to the floating diffusion FD. The floating diffusion FD converts the transferred electrical charge into a voltage signal and outputs the voltage signal to the amplifying transistor SF. The amplifying transistor SF amplifies the voltage signal outputted from the floating diffusion FD. The row select transistor SEL outputs the voltage signal amplified by the amplifying transistor SF, as a pixel signal Video to a read circuit (not shown).

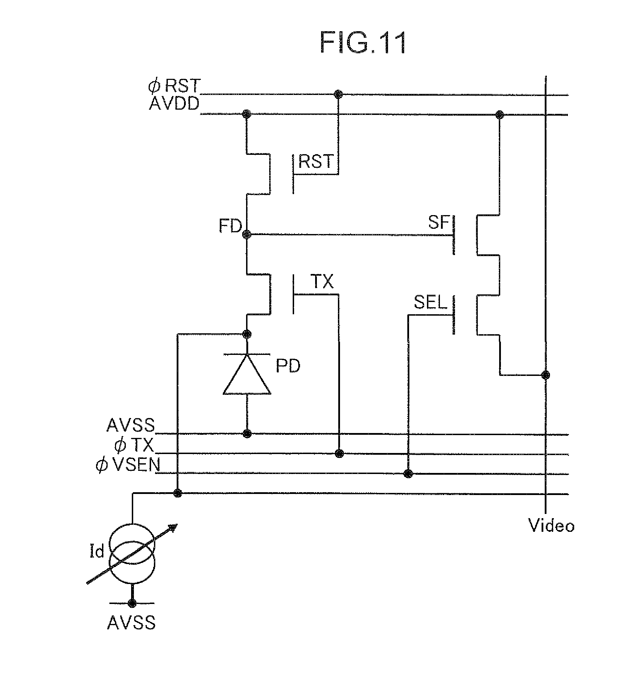

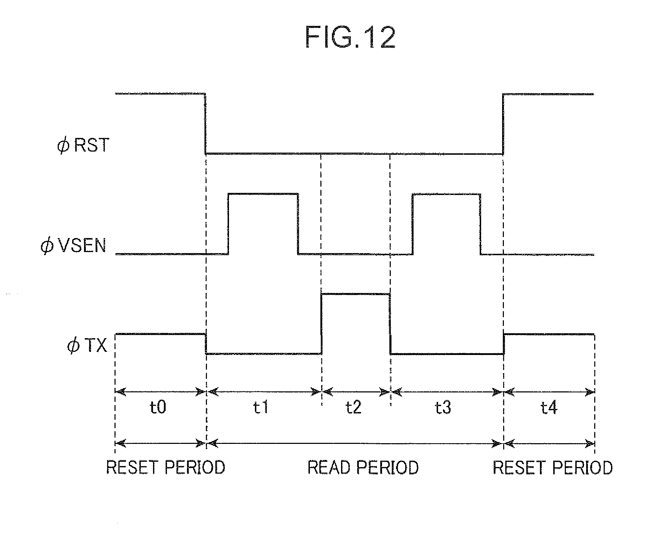

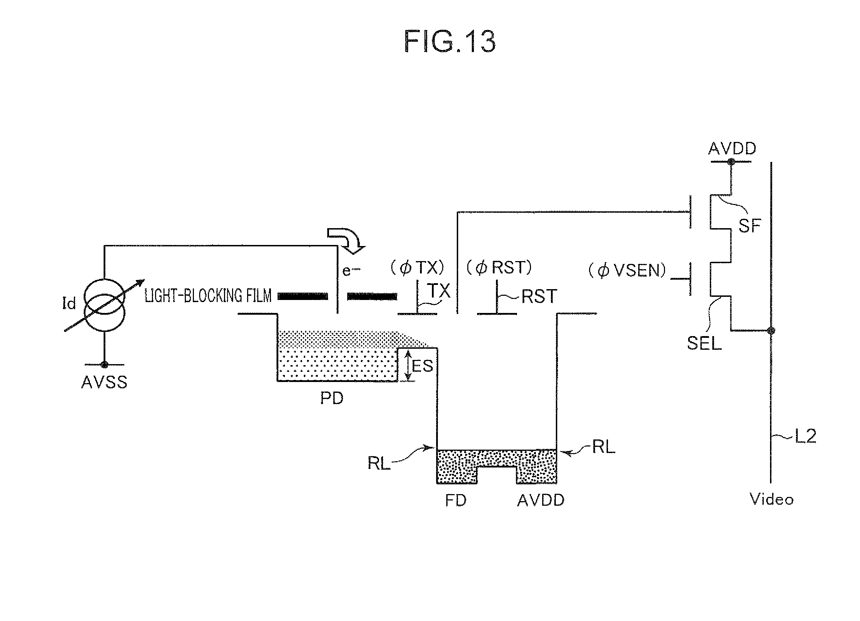

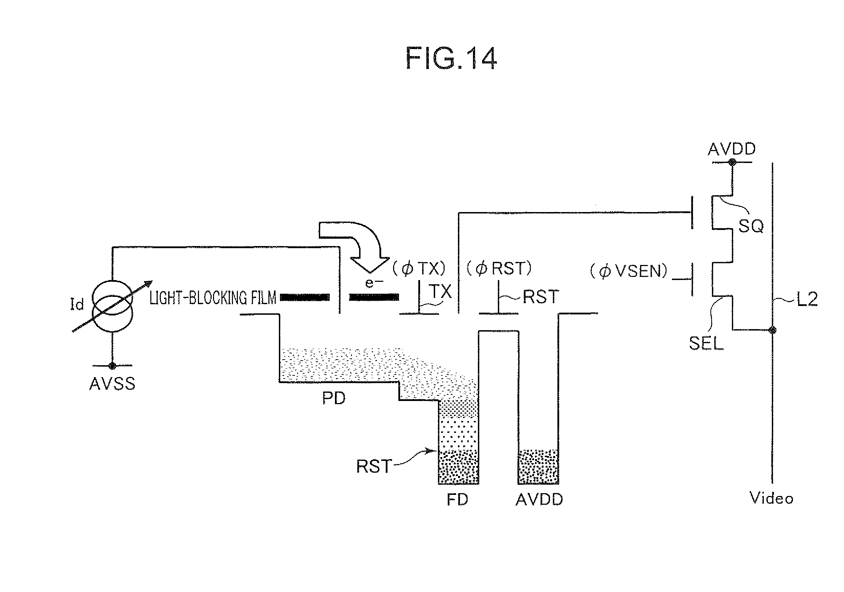

Fig. 12 shows a timing chart depicting an operation of the dummy pixel shown in Fig. 11. Figs. 13 and 14 show energy potential diagrams of the dummy pixel shown in Fig. 11. The energy potential diagrams shown in Figs. 13 and 14 indicate that the further toward the bottom, the higher the voltage.

At a period t0, settings of φRST = Hi, φVSEN = Lo, and φTX = Mid are made and the reset transistor RST resets the floating diffusion FD. Consequently, a voltage of the floating diffusion FD is set to a reset level RL (refer to Fig. 13). In this case, Mid denotes an intermediate level between the high level and the low level, whereby a level of the inflection point PX is determined by the Mid level.

Returning now to Fig. 12, at a period t1, settings of φRST = Lo, φVSEN = Hi, and φTX = Lo are made and the row select transistor SEL outputs the reset level of the floating diffusion FD as a noise component of the pixel signal Video to the read circuit. In this case, in Fig. 13, after a gate of the reset transistor RST is closed, the row select transistor SEL outputs the reset level RL amplified by the amplifying transistor SF as the noise component of the pixel signal Video to the read circuit.

Returning now to Fig. 12, at a period t2, settings of φRST = Lo, φVSEN = Lo, and φTX = Hi are made and the transfer transistor TX transfers the electrical charge accumulated by the photodiode PD to the floating diffusion FD. In this case, as shown in Fig. 14, the electrical charge transferred by the photodiode PD causes the voltage of the floating diffusion FD to decrease with the reset level RL read at the period t1 as an offset.

Returning now to Fig. 12, at a period t3, settings of φRST = Lo, φVSEN = Hi, and φTX = Lo are made and the row select transistor SEL outputs a voltage level of the floating diffusion FD as a noise component + signal component of the pixel signal Video to the read circuit. In this case, as shown in Fig. 14, after a gate of the transfer transistor TX is closed, the row select transistor SEL outputs the voltage of the floating diffusion FD amplified by the amplifying transistor SF as the noise component + signal component of the pixel signal Video to the read circuit.

Returning now to Fig. 12, at a period t4, settings of φRST = Hi, φVSEN = Lo, and φTX = Mid are made, the floating diffusion FD is reset by the reset transistor RST, and accumulation of an electrical charge of a next frame is started by the photodiode PD.

Moreover, periods t0 and t4 shown in Fig. 12 represent reset periods and period (t1 + t2 + t3) represents a read period.

However, with the technique disclosed in Patent Document 1, when φTX = Hi is set and the transfer transistor TX starts transferring an electrical charge to the floating diffusion FD, an electrical charge accumulated by the photodiode PD decreases, whereby the constant current source Id which performs constant current control inadvertently injects a greater electrical charge into the photodiode PD in an attempt to compensate for the decreased electrical charge. Consequently, a greater electrical charge than during photography is injected into the photodiode PD, resulting in a problem in that photoelectric conversion characteristics of a dummy pixel cannot be accurately traced and the inflection point PX cannot be accurately measured.

Patent Document 1: Japanese Patent Application Laid-Open No. 2007-288479

### Summary of the Invention

An object of the present invention is to provide a solid-state imaging device capable of accurately tracing photoelectric conversion characteristics and accurately measuring an inflection point.

### Brief Description of the Drawings

[Fig. 1] Fig. 1 shows an overall configuration diagram of a solid-state imaging device according to a first embodiment of the present invention;
[Fig. 2] Fig. 2 shows a circuit diagram of a normal pixel shown in Fig. 1;
[Fig. 3] Fig. 3 shows an energy potential diagram of the normal pixel shown in Fig. 2;
[Fig. 4] Fig. 4 shows a circuit diagram of a dummy pixel shown in Fig. 1;
[Fig. 5] Fig. 5 shows a timing chart of the dummy pixel shown in Fig. 4;
[Fig. 6] Fig. 6 shows an energy potential diagram of the dummy pixel shown in Fig. 5;
[Fig. 7] Fig. 7 shows a flow chart when the solid-state imaging device shown in Fig. 1 traces photoelectric conversion characteristics of a single dummy pixel G2;
[Fig. 8] Fig. 8 is a graph showing photoelectric conversion characteristics of a dummy pixel traced by a tracing unit;
[Fig. 9] Fig. 9 shows an overall configuration diagram of a solid-state imaging device according to a second embodiment of the present invention;
[Fig. 10] Fig. 10 is a graph showing photoelectric conversion characteristics of a pixel having linear characteristics and logarithmic characteristics;
[Fig. 11] Fig. 11 shows a circuit diagram of a dummy pixel according to Patent Document 1;
[Fig. 12] Fig. 12 shows a timing chart depicting an operation of the dummy pixel shown in Fig. 11;
[Fig. 13] Fig. 13 shows an energy potential diagram of the dummy pixel shown in Fig. 11; and
[Fig. 14] Fig. 14 shows an energy potential diagram of the dummy pixel shown in Fig. 11.

### Best Mode for Carrying Out the Invention

### (First embodiment)

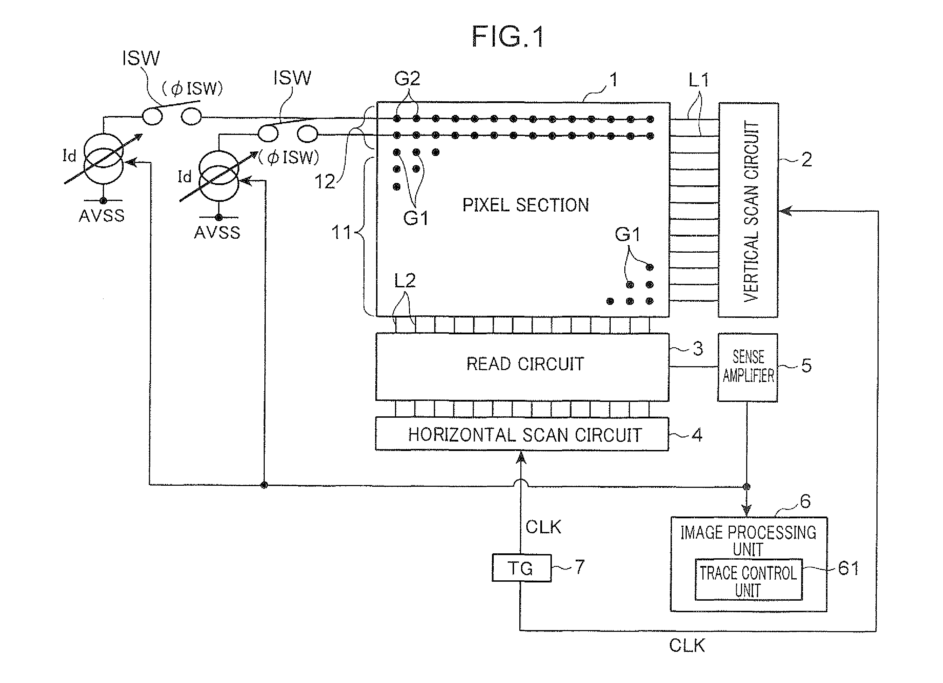

Fig. 1 shows an overall configuration diagram of a solid-state imaging device according to a first embodiment of the present invention. The solid-state imaging device is constituted by, for example, a column ADC CMOS image sensor and comprises an pixel section 1, a vertical scan circuit 2, a read circuit 3, a horizontal scan circuit 4, a sense amplifier 5, an image processing unit 6, a timing generator (TG) 7, and a constant current source Id. Moreover, the image processing unit 6 includes a trace control unit 61. The trace control unit 61 and the vertical scan circuit 2 constitute a tracing unit.

The pixel section 1 comprises, for example, an embedded photodiode, and includes pixels having photoelectric conversion characteristics including linear characteristics and logarithmic characteristics arranged in a matrix pattern. Specifically, the pixel section I comprises a normal pixel section 11 made up of formal pixels G1 for exposing a subject and a dummy pixel section 12 made up of dummy pixels G2 having light-blocked photoelectric conversion elements.

In the present embodiment, the dummy pixels G2 are linearly arranged at predetermined rows in the pixel section 1 such as at each column in a first row and each column in a second row in the pixel section 1. However, this is merely an example and the dummy pixels G2 may be arranged only in the first row of the pixel section 1 or in any one or a plurality of rows other than the first row. In addition, the dummy pixels G2 need not be arranged in each column and may instead be arranged thinned out such as in every other column or every three columns. Furthermore, the dummy pixel section 12 may be provided in a vertically-oriented rectangular pattern by arranging the dummy pixels G2 in any one or a plurality of columns of the pixel section 1.

The vertical scan circuit 2 is constituted by, for example, a shift register and is connected to each row of the pixel section 1 via a row signal line L1 and, according to a clock signal CLK outputted from the timing generator 7, cyclically outputs a row select signal for selecting each row of the pixel section 1 from an upper side to a lower side or from the lower side to the upper side in a sub-scanning direction to scan each row of the pixel section 1. Moreover, a random access circuit may be adopted as the vertical scan circuit 2 instead of the shift register.

The read circuit 3 is constituted by, for example, a read circuit of an integral AD converter provided common to each pixel in each column of the pixel section 1. The read circuit 3 reads out a pixel signal from pixels in each column via a vertical signal line L2, performs analog-digital conversion on the read pixel signal by comparing the pixel signal with a ramp signal, and outputs the analog-digital converted pixel signal to the sense amplifier 5. In this case, the read circuit 3 comprises a CDS (Correlated Double Sampling) circuit, a comparator, a counter, a latch circuit, and the like.

The CDS circuit removes a noise component of the pixel signal outputted from the pixel section 1. The comparator compares the pixel signal outputted from the CDS circuit with a ramp signal, and when the ramp signal reaches a level of the pixel signal, the comparator inverts output. The counter counts a period of time from an input of a ramp signal to the comparator until output of the comparator is inverted. The latch circuit latches a count value by the counter.

Moreover, while a read circuit of an integral AD converter has been adopted as the read circuit, the present invention is not limited thereto and a read circuit of a successive-approximation AD converter may be adopted instead. In addition, an analog read circuit not including an analog-digital conversion function may also be adopted.

The horizontal scan circuit 4 is constituted by, for example, a shift register and, according to a clock signal CLK outputted from the timing generator 7, cyclically outputs a column select signal for selecting each column of the pixel section 1 to the read circuit 3 of each column, and scans the respective read circuits 3 from, for example, left to right or right to left. A plurality of vertical signal lines L2 exists in correspondence to the respective columns of the pixel section 1. In addition, each vertical signal line L2 is connected to the respective pixels in a corresponding column.

The sense amplifier 5 amplifies pixel signals of the respective pixels sequentially outputted from the read circuits with a predetermined gain and outputs the amplified signals to the image processing unit 6.

The image processing unit 6 is constituted by, for example, a dedicated hardware circuit and performs predetermined image processing on digital pixel signals sequentially outputted from the read circuit 3 via the sense amplifier 5. In this case, predetermined image processing includes image processing such as white balance correction in which image processing for linear characteristics is executed on pixel signals read by linear characteristics and image processing for logarithmic characteristics is executed on pixel signals read by logarithmic characteristics.

The trace control unit 61 traces photoelectric conversion characteristics of dummy pixels G2 by varying a current value outputted from constant current sources Id and obtaining pixel signals outputted from the read circuit 3.

In this case, the trace control unit 61 turns off a switch ISW during a predetermined read period in which the read circuit 3 reads pixel signals from the dummy pixels G2.

Specifically, the trace control unit 61 outputs a setting signal for setting a current value of the constant current source Id to the constant current source Id and causes the constant current source Id to output a current value of a predetermined level. In addition, the trace control unit 61 causes the constant current source Id to output a plurality of current values, acquires output values of digital pixel signals outputted from the read circuit 3 with respect to the respective current values, and traces the photoelectric conversion characteristics of each dummy pixel G2.

Furthermore, the trace control unit 61 instructs the vertical scan circuit 2 to output a switch signal (hereinafter denoted as "φISW") for turning the switch ISW on/off, and turns the switch ISW on/off by causing the vertical scan circuit 2 to output φISW to the switch ISW. However, this is merely an example and the trace control unit 61 may directly output φISW to the switch ISW.

The timing generator 7 outputs a clock signal CLK to the vertical scan circuit 2 and the horizontal scan circuit 4 to drive both circuits.

The constant current sources Id are provided in correspondence to respective rows in the dummy pixel section 12 and outputs a current value according to the setting signal outputted from the trace control unit 61. In other words, the constant current sources Id are connected to respective dummy pixels G2 arranged on respective columns of a given single row. In this case, the constant current sources Id monitor current values outputted to the dummy pixels G2 and perform feedback control so that the current values maintain a current value corresponding to the setting signal.

Next, operations of the solid-state imaging device shown in Fig. 1 will be briefly described. When one row is selected by the vertical scan circuit 2, the read circuit 3 sequentially reads a noise component and a noise component + signal component of pixel signals read at pixels arranged in the selected row. After the noise component is cancelled out, the read pixel signals are subjected to analog-digital conversion and then latched by the latching unit.

Subsequently, respective columns of the pixel section 1 are sequentially selected by the horizontal scan circuit 4 and the latch unit sequentially outputs digital pixel signals to be latched to the image processing unit 6 via the sense amplifier 5.

In this case, pixel signals of the dummy pixels G2 may be read every time the pixel section 1 exposes one or a plurality of pieces of image data, upon power activation of the solid-state imaging device, or after a certain period of time lapses after power activation.

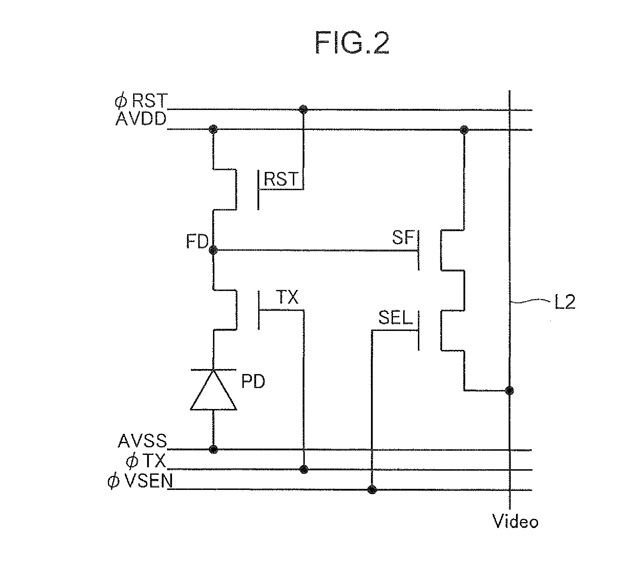

Fig. 2 shows a circuit diagram of the normal pixel G1 shown in Fig. 1. The normal pixel G1 comprises a photodiode PD as a photoelectric conversion element, a transfer transistor TX, a reset transistor RST, an amplifying transistor SF, a row select transistor SEL, and a floating diffusion FD.

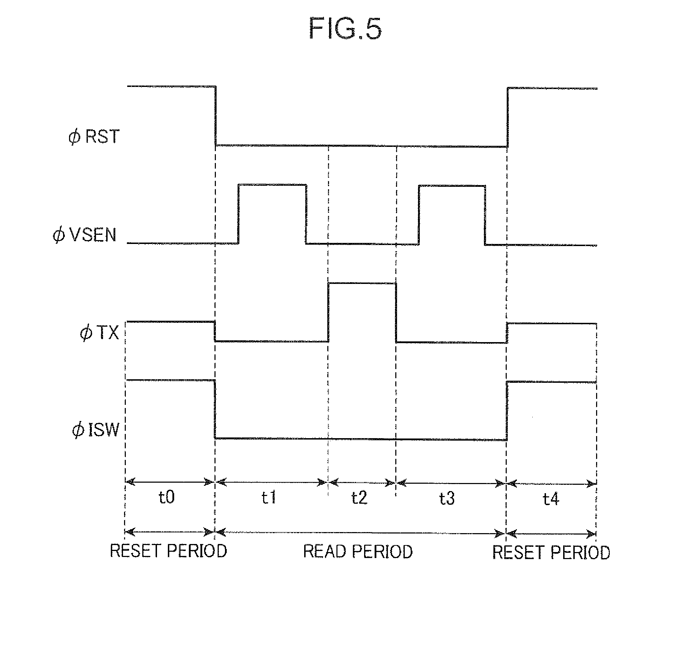

The photodiode PD receives light reflected off of a subject and accumulates an electrical charge corresponding to the received light intensity. The transfer transistor TX transfers an electrical charge accumulated by the photodiode PD to the floating diffusion FD. The floating diffusion FD generates a voltage signal corresponding to the electrical charge transferred from the transfer transistor TX. Due to a positive drive voltage (hereinafter denoted as "AVDD"), the reset transistor RST resets the floating diffusion FD at a reset period which precedes the read period shown in Fig. 5 and sets a voltage level of the floating diffusion FD to a reset level.

The amplifying transistor SF amplifies the voltage of the floating diffusion FD. The row select transistor SEL outputs the voltage amplified by the amplifying transistor SF as a pixel signal Video to the vertical signal line L2.

A negative drive voltage AVSS (hereinafter denoted as "AVSS") is inputted to the photodiode PD and a source of the transfer transistor TX is connected to a cathode of the photodiode PD. In this case, a negative voltage level or a ground level may be adopted as AVSS.

A signal φTX (hereinafter denoted as "φTX") for turning on/off the transfer transistor TX is inputted to a gate of the transfer transistor TX, and a drain of the transfer transistor TX is connected to the reset transistor RST. In this case, the transfer transistor TX is constituted by, for example, an n-channel field effect transistor which is turned on when φTX = Hi (high level) and turned off when φTX = Lo (low level).

The floating diffusion FD is formed at a connection point of the transfer transistor TX and the reset transistor RST, and generates a voltage signal corresponding to an electrical charge transferred from the transfer transistor TX.

A positive drive voltage AVDD (hereinafter denoted as "AVDD") is inputted to a drain of the reset transistor RST, and a reset signal φRST (hereinafter denoted as "φRST") is inputted to a gate of the reset transistor RST. In this case, the reset transistor RST is constituted by, for example, an n-channel field effect transistor which is turned on when φRST = Hi and turned off when φRST = Lo.

Moreover, AVDD and AVSS are outputted from, for example, a constant current source (not shown). In addition, when ground level is adopted as AVSS, one end of a line along which AVSS is transmitted may be connected to ground. Furthermore, φRST, φTX, and φVSEN are outputted from, for example, the vertical scan circuit 2. In other words, specifically, a row signal line L1 connected to the normal pixel G1 shown in Fig. 1 is constituted by lines which transmit φRST, φTX, and φVSEN.

With the amplifying transistor SF, a gate is connected to the floating diffusion FD, AVDD is inputted to a drain, and a source is connected to the row select transistor SEL.

With the row select transistor SEL, a row select signal φVSEN (hereinafter, denoted as "φVSEN") is inputted to a gate, a drain is connected to the amplifying transistor SF, and a source is connected to the vertical signal line L2.

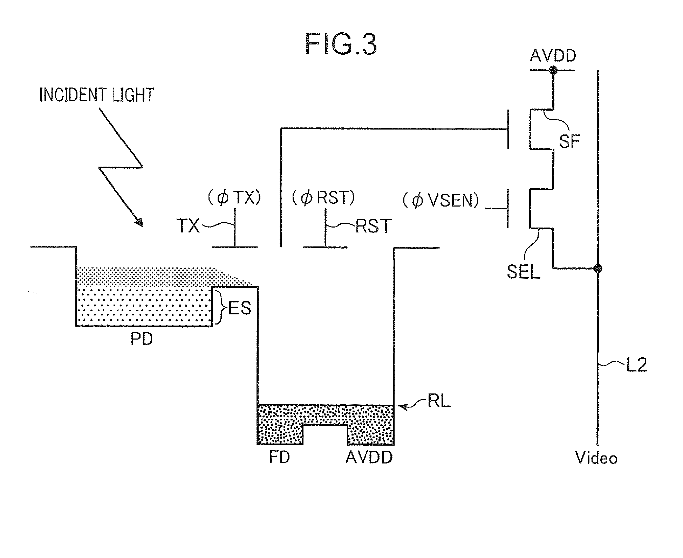

Next, operations of the normal pixel G1 shown in Fig. 2 will be described. Since a timing chart depicting operations of the normal pixel G1 shown in Fig. 2 is the same as Fig. 12, Fig. 12 will be used. Fig. 3 shows an energy potential diagram of the normal pixel G1 shown in Fig. 2. Moreover, in the energy potential diagram shown in Fig. 3, the further toward the bottom, the higher the voltage.

First, at a period t0, settings of φRST = Hi, φVSEN = Lo, and φTX = Mid are made and the reset transistor RST resets the floating diffusion Fix. Consequently, as shown in Fig. 3, a voltage of the floating diffusion FD is set to a reset level RL. In this case, the reset level RL varies from pixel to pixel.

At this point, the photodiode PD receives incident light from a subject and accumulates an electrical charge. In addition, the transfer transistor TX is set such that φTX = Mid. In this case, Mid denotes an intermediate level between the high level and the low level, whereby a level of the inflection point PX is determined by the Mid level.

In other words, since a state is entered where a gate of the transfer transistor TX is half open, when light intensity of the incident light is smaller than a certain value, the electrical charge accumulated in the photodiode PD is unable to exceed an energy barrier ES of the transfer transistor TX. Therefore, accumulation of the electrical charge of the photodiode PD increases linearly according to the light intensity of the incident light and photoelectric conversion characteristics of the normal pixel G1 shown in Fig. 2 assumes linear characteristics.

On the other hand, when the light intensity of the incident light is greater than the certain value, a portion of the electrical charge accumulated in the photodiode PD exceeds the energy barrier ES of the transfer transistor TX and leaks to the floating diffusion FD. Therefore, accumulation of the electrical charge of the photodiode PD increases logarithmically according to the light intensity of the incident light, and photoelectric conversion characteristics of the normal pixel G1 shown in Fig. 2 assumes logarithmic characteristics.

Returning now to Fig. 12, at a period t1, settings of φRST = Lo, φVSEN = Hi, and φTX = Lo are made, the gate of the reset transistor RST is closed, and the row select transistor SEL outputs the reset level RL of the floating diffusion FD as a noise component of a pixel signal Video to the read circuit 3.

At a period t2, settings of φRST = Lo, φVSEN = Lo, and φTX = Hi are made and the transfer transistor TX. opens the gate and transfers the electrical charge accumulated by the photodiode PD to the floating diffusion FD. In this case, as shown in Fig. 3, the electrical charge transferred from the photodiode PD causes the voltage of the floating diffusion FD to decrease with the reset level RL read at the period t1 as an offset.

Returning now to Fig. 12, at a period t3, settings of φRST = Lo, φVSEN = Hi, and φTX = Lo are made and the row select transistor SEL outputs a voltage signal of the floating diffusion FD as a noise component + signal component of the pixel signal Video to the read circuit 3.

In this case, in Fig. 3, after a gate of the transfer transistor TX is closed, the row select transistor SEL outputs the voltage of the floating diffusion FD amplified by the amplifying transistor SF as the noise component + signal component of the pixel signal Video to the read circuit 3.

Returning now to Fig. 12, at a period t4, settings of φRST = Hi, φVSEN = Lo, and φTX = Mid are made, the reset transistor RST is turned on and the row select transistor SEL is turned off, the floating diffusion FD is reset by the reset transistor RST, and the photodiode PD starts accumulating an electrical charge of a next frame.

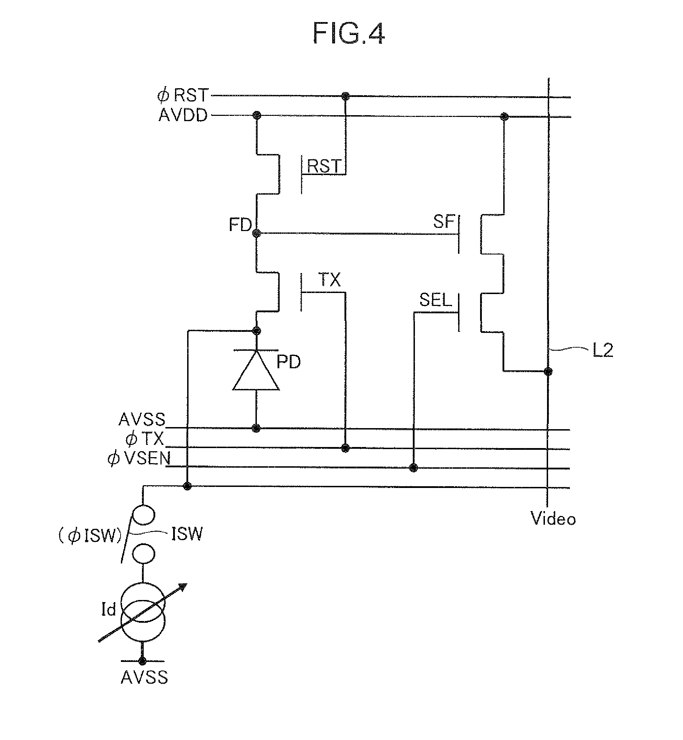

Fig. 4 shows a circuit diagram of the dummy pixel G2 shown in Fig. 1. The dummy pixel G2 shown in Fig. 4 is configured such that, in the normal pixel G1 shown in Fig. 2, a switch ISW and a constant current source Id are connected to the photodiode PD. In addition, the photodiode PD is configured such that a light-blocking film is formed at an opening and incident light cannot be received, and an electrical change is injected by a constant current from the constant current source Id and is accumulated.

One end of the switch ISW is connected to a cathode of the photodiode PD and another end is connected to the constant current source Id. One end of the constant current source Id is connected to the switch ISW and a drive voltage AVSS is inputted to another and of the constant current source Id. Moreover, φISW is outputted from the vertical scan circuit 2 and the constant current source Id is provided at each row of the dummy pixel section 12. In other words, a row signal line L1 connected to the dummy pixel G2 shown in Fig. 1 is constituted by a line which transmits φISW in addition to lines which respectively transmit φRST, φTX, and φSEL.

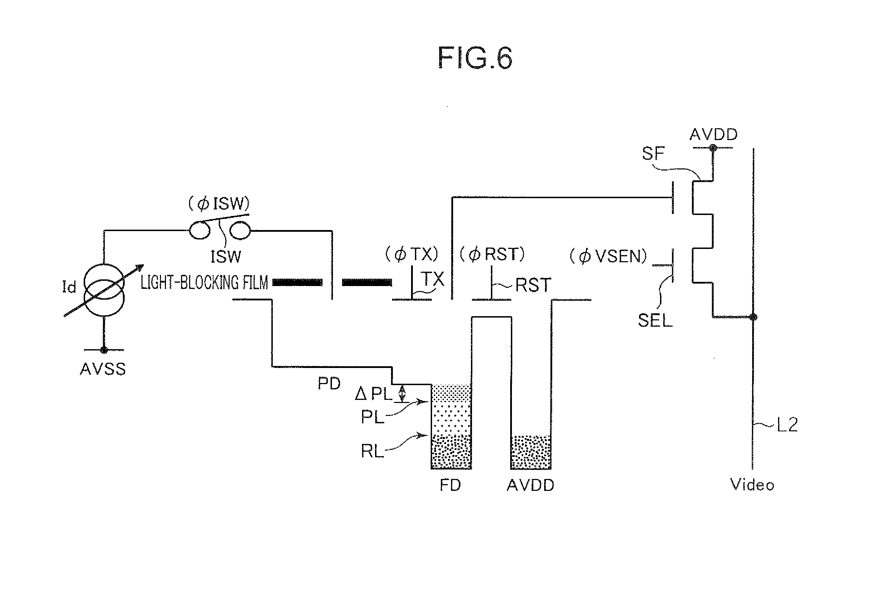

Fig. 5 shows a timing chart of the dummy pixel G2 shown in Fig. 4. Fig. 6 shows an energy potential diagram of the dummy pixel G2 shown in Fig. 5.

First, at the period t0 in Fig. 5, settings of φRST = Hi, φVSEN = Lo, φTX = Mid, and φISW = Hi are made and the reset transistor RST resets the floating diffusion FD. Consequently, as shown in Fig. 6, a voltage of the floating diffusion FD is set to a reset level RL. At this point, the switch ISW is turned on and an electrical charge is injected into the photodiode PD by the constant current source Id.

Returning now to Fig. 5, at a period t1, settings of φRST = Lo, φVSEN = Hi, φTX = Lo, and φISW = Lo are made and the row select transistor SEL outputs the reset level RL of the floating diffusion FD as a noise component of the pixel signal Video to the read circuit 3.

Next, at a period t2, settings of φRST = Lo, φVSEN = Lo, φTX = Hi, and φISW = Lo are made and the transfer transistor TX opens the gate and transfers the electrical charge accumulated in the photodiode PD to the floating diffusion FD.

In this case, since the switch ISW is turned off, the injection of the electrical charge to the photodiode PD from the constant current source Id is blocked even if the photodiode PD becomes empty. Therefore, as shown in Fig. 6, the voltage of the floating diffusion FD can be set similar to a level PL during imaging. As a result, with the dummy pixel G2 according to the present embodiment, photoelectric conversion characteristics can be traced with high accuracy and the inflection point PX can be measured with high accuracy.

On the other hand, in a conventional dummy pixel, the constant current source Id and the photodiode PD are connected without involving the switch ISW. Therefore, as shown in Fig. 6, when the gate of the transfer transistor TX is opened, the electrical charge of the photodiode PD is transferred to the floating diffusion FD, and the photodiode PD becomes empty, the constant current source Id injects an excessive electrical charge to the photodiode PD in an attempt to compensate.

Accordingly, a greater electrical charge than during imaging is transferred to the floating diffusion FD, and a voltage of the floating diffusion FD becomes lower than a level PL during imaging by ΔPL. As a result, with a conventional dummy pixel, photoelectric conversion characteristics cannot be traced with high accuracy.

Returning now to Fig. 5, at a period t3, settings of φRST = Lo, φVSEN = Hi, φTX = Lo, and φISW = Lo are made and the row select transistor SEL outputs a voltage of the floating diffusion FD as a noise component + signal component of the pixel signal Video to the read circuit 3.

At period t4, settings of φRST= Hi, φVSEN = Lo, φTX = Mid, and φISW = Hi are made, and the reset transistor RST resets the floating diffusion FD and the photodiode PD starts accumulating an electrical charge of a next frame.

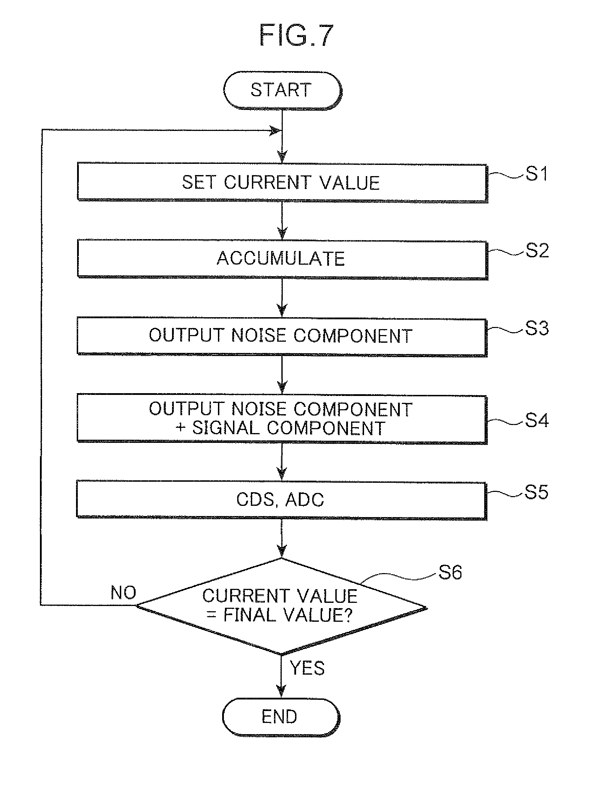

Fig. 7 shows a flow chart when tracing photoelectric conversion characteristics of a single dummy pixel G2 having the solid-state imaging device shown in Fig. 1.

First, the trace control unit 61 outputs a setting signal to a constant current source Id connected to a dummy pixel G2 that is a trace object in order to set a current value of the constant current source Id (step S1). Consequently, the constant current source Id outputs a constant current according to the setting signal to the dummy pixel G2.

Next, at the period t0 shown in Fig. 5, the dummy pixel G2 resets the floating diffusion FD and causes the photodiode PD to accumulate an electrical charge (step S2).

Next, at the period t1 shown in Fig.5, the dummy pixel G2 outputs a pixel signal Video of a noise component (step S3). Next, at the period t2 shown in Fig.5, the dummy pixel G2 transfers the electrical charge accumulated in the photodiode PD to the floating diffusion FD. Next, at the period t3 shown in Fig.5, the dummy pixel G2 outputs a pixel signal Video of a noise component + signal component (step S4).

Next, the read circuit 3 connected to the dummy pixel G2 that is the trace object subtracts the pixel signal Video of the noise component from the pixel signal Video of the noise component + signal component outputted from the dummy pixel G2 to cancel out the noise component, applies analog-digital conversion to the pixel signal Video of which the noise component has been cancelled, and outputs the same to the trace control unit 61 (step S5).

Next, if the set current value is a predetermined final value (YES in step S6), the trace control unit 61 ends processing. However, if the set current value is not the final value (NO in step S6), the trace control unit 61 returns processing to step S 1 to set a next current value of the constant current source Id (step S1). Subsequently, processing of steps S2 to S6 is repetitively executed and the trace control unit 61 traces photoelectric conversion characteristics of the dummy pixel G2.

In this case, when the trace control unit 61 traces photoelectric conversion characteristics of the dummy pixel G2, since a plurality of current values to be outputted by the constant current source Id is determined in advance, the trace control unit 61 need only set the current value of the constant current source Id so that the plurality of current values set in advance sequentially increases or decreases.

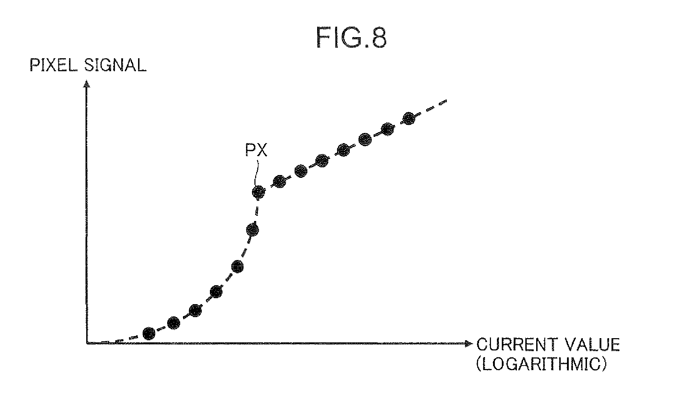

Fig. 8 is a graph showing photoelectric conversion characteristics of the dummy pixel G2 traced by the trace control unit 61. In Fig. 8, an ordinate represents an output value of the pixel signal Video inputted to the trace control unit 61 and an abscissa represents a current value outputted by the constant current source Id. Moreover, the abscissa is expressed as a logarithmic scale.

In Fig. 8, each plotted point represents a measure point of photoelectric conversion characteristics acquired by the trace control unit 61 every time the flow chart shown in Fig. 7 makes a loop.

The trace control unit 61 acquires a plurality of measure points by sequentially increasing or reducing current values outputted from the constant current source Id and traces photoelectric conversion characteristics of the dummy pixel G2.

As shown in Fig. 8, it is apparent that the photoelectric conversion characteristics of the dummy pixel G2 have linear characteristics until the current value outputted from the constant current source Id exceeds the inflection point PX and have logarithmic characteristics once the inflection point PX is exceeded. Moreover, since the abscissa is expressed by a logarithmic scale in Fig. 8, linear characteristics describe a downward-convex curve while logarithmic characteristics describe a straight line that gently rises from left to right.

In addition, for example, the trace control unit 61 performs linear interpolation on the plurality of acquired measure points to identify the inflection point PX. At this point, as shown in Fig. 1, the trace control unit 61 may associate, and store in a memory (not shown), an average value of inflection points PX in the respective columns of the dummy pixel section 12 as an inflection point PX of the respective normal pixels G1 in the respective columns of a corresponding normal pixel section 11 such as obtaining an average value of the inflection points PX of the respective dummy pixels G2 in a first column of the dummy pixel section 12 as the inflection point PX of the respective normal pixels G1 in a first column of the normal pixel section 11, obtaining an average value of the inflection points PX of the respective dummy pixels G2 in a second column of the dummy pixel section 12 as the inflection point PX of the respective normal pixels G1 in a second column of the normal pixel section 11, and so on.

In addition, the trace control unit 61 may associate an average value of inflection points PX of all dummy pixels G2 of the dummy pixel section 12 as an inflection point PX of each pixel in the normal pixel section 11.

Subsequently, upon acquiring a pixel signal Video of a given normal pixel G1, the image processing unit 6 may execute image processing by judging whether the pixel signal Video is a pixel signal Video in a linear characteristics region or a pixel signal Video in a logarithmic characteristics region using the inflection point PX associated with the normal pixel G1.

As described above, with the solid-state imaging device according to the present embodiment, the photodiode PD is connected to the constant current source Id via the switch ISW in the dummy pixel G2 as shown in Fig. 4 and the switch ISW is turned off at a read period shown in Fig. 5.

Therefore, when an electrical charge is transferred from the photodiode PD to the floating diffusion FD, injection of the electrical charge from the constant current source Id is blocked and photoelectric conversion characteristics of a dummy pixel G2 can be traced under conditions similar to during imaging. As a result, the photoelectric conversion characteristics of the dummy pixel G2 can be traced with higher accuracy and an inflection point PX can be identified with high accuracy.

Moreover, when dummy pixels G2 of the pixel section 1 are linearly provided in a vertical direction, one or a plurality of constant current sources Id may be provided in correspondence to each column of the dummy pixels G2.

In addition, while the trace control unit 61 is provided in the image processing unit 6 in the present embodiment, such a configuration is not restrictive and the trace control unit 61 may be provided outside of the image processing unit 6. In this case, for example, the trace control unit 61 may be provided at a control unit (not shown) which controls the entire solid-state imaging device. In this case, the trace control unit 61 is realized by, for example, a CPU constituting the control unit executing a control program stored in a ROM.

In addition, while one constant current source Id is provided in correspondence to each row of the dummy pixel section 12 in the present embodiment, such a configuration is not restrictive and a plurality of constant current sources Id may be provided in correspondence to each row. In this case, a maximum value of current values inputted to the dummy pixels G2 can easily be set by increasing or reducing the number of connected constant current sources Id.

### (Second embodiment)

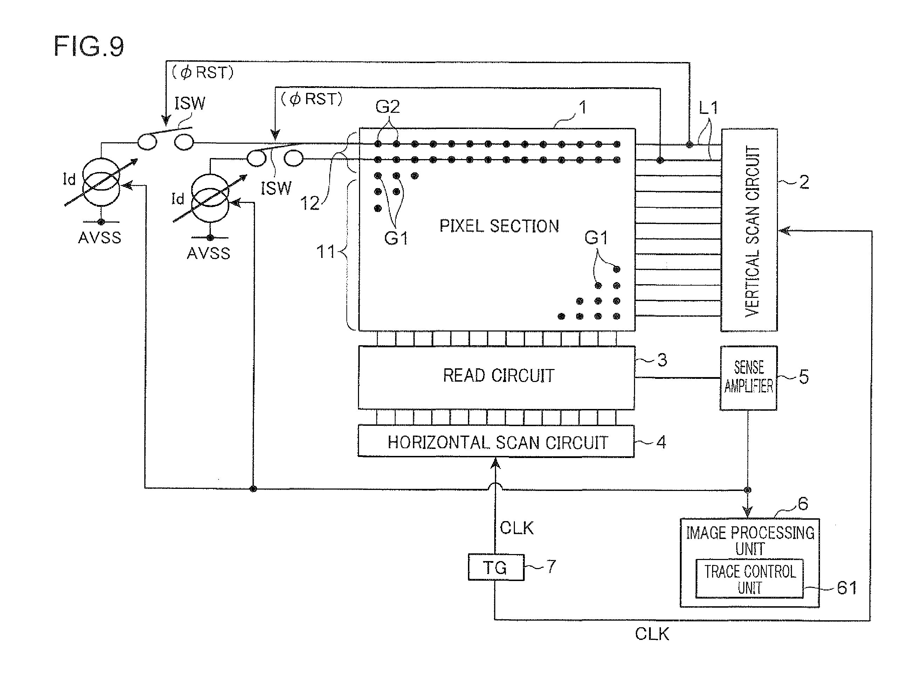

With a solid-state imaging device according to a second embodiment, φRST which had been outputted to dummy pixels G2 in the first embodiment is replaced with φISW and is also outputted to a switch ISW. Fig. 9 shows an overall configuration diagram of a solid-state imaging device according to the second embodiment of the present invention. Moreover, in the present embodiment, a description of elements similar to those of the first embodiment will be omitted.

In Fig. 9, a row signal line L1 connected to the dummy pixels G2 is constituted by lines respectively transmitting φRST, φTX, and φVSEN. The line transmitting φRST is connected to a reset transistor RST of the dummy pixels G2 and also to the switch ISW

Specifically, a line that transmits φPST of a corresponding row is connected to each constant current source Id, such as a line that transmits φRST outputted to dummy pixels G2 in a first row is connected to the constant current source Id of the first row, a line that transmits φRST outputted to dummy pixels G2 in a second row is connected to the constant current source Id of the second row, and so on.

Fig. 5 shows that φRST and φISW share a same waveform. Therefore, even when φRST is outputted to the switch ISW as φISW, the switch ISW can be turned on at a reset period and turned off at a read period. As a result, a same operational effect as the solid-state imaging device according to the first embodiment can be obtained.

In addition, consequently, a circuit for generating φISW is no longer required and simplification and downsizing of circuit configuration can be achieved.

Technical features of the solid-state imaging devices described above can be summarized as follows.

(1) A solid-state imaging device according to an aspect of the present invention comprises a pixel section in which pixels having: photoelectric conversion characteristics including linear characteristics and logarithmic characteristics are arranged in a matrix pattern; and a read circuit which reads out a pixel signal from each pixel, wherein the pixel section includes a normal pixel section made up of normal pixels for exposing a subject and a dummy pixel section made up of dummy pixels having a light-blocked photoelectric conversion element, the solid-state imaging device further having: a constant current source which injects a constant current to the photoelectric conversion elements of the dummy pixels, a switch provided between the constant current sources and the photoelectric conversion elements of the dummy pixels, and a tracing unit which traces photoelectric conversion characteristics of the dummy pixels by varying a current value outputted from the constant current sources and obtaining pixel signals outputted from the read circuit, the tracing unit being configured to turn off the switch at a predetermined read period in which the read circuit reads pixel signals from the dummy pixels.

According to this configuration, the photoelectric conversion element and the constant current source of a dummy pixel are connected to each other via a switch. In addition, the switch is turned off during a predetermined read period in which the read circuit reads a pixel signal from the dummy pixel.

Therefore, during the read period, injection of an electrical charge from the constant current source to the photoelectric conversion element of the dummy pixel can be blocked and a same amount of electrical charge as during imaging can be injected into the photoelectric conversion element of the dummy pixel. As a result, photoelectric conversion characteristics of a dummy pixel can be accurately traced and an inflection point can be accurately measured.

(2) In addition, preferably, the dummy pixels are linearly arranged in a predetermined row or a predetermined column in the pixel section and one or a plurality of the constant current sources are provided in correspondence to each row in which the dummy pixels are arranged.

According to this configuration, when dummy pixels are linearly arranged in a predetermined row, photoelectric conversion characteristics of normal pixels in each column can be estimated from photoelectric conversion characteristics of dummy pixels in each column. In addition, when dummy pixels are linearly arranged in a predetermined column, photoelectric conversion characteristics of normal pixels in each row can be estimated from photoelectric conversion characteristics of dummy pixels in each row. Therefore, image processing can be applied with higher accuracy on pixel signals obtained from respective normal pixels.

(3) Preferably, one or a plurality of constant current sources are provided in correspondence to each row in which the dummy pixels are arranged.

According to this configuration, since one or a plurality of the constant current sources are provided in correspondence to each row of the dummy pixels, photoelectric conversion characteristics of dummy pixels can be readily obtained for each row.

(4) Preferably, the tracing unit has: a vertical scan circuit which vertically scans each row of the pixel section; and a trace control unit which instructs the vertical scan circuit to output the switch signal, wherein the vertical scan circuit outputs a switch signal for turning on/off the switch based on an instruction from the trace control unit.

According to this configuration, since switch signals are outputted from the vertical scan circuit, photoelectric conversion characteristics of dummy pixels can be readily obtained for each row.

(5) Preferably, the dummy pixels have: a floating diffusion to which an electrical charge accumulated by the photoelectric conversion element is transferred and which generates a voltage signal according to the transferred electrical charge; and a reset transistor which is turned on/off by a reset signal outputted from the vertical scan circuit and which resets the floating diffusion at a predetermined reset period preceding the read period, wherein the vertical scan circuit outputs the reset signal as the switch signal to the switch.

According to this configuration, since the reset signal doubles as a switch signal, there is no need to separately provide a circuit for generating switch signals. As a result, a circuit size can be reduced and control can be simplified.

(6) Preferably, the dummy pixels have: a transfer transistor which transfers an electrical charge accumulated at the photoelectric conversion element to the floating diffusion; an amplifying transistor which amplifies a voltage signal generated by the floating diffusion; and a row select transistor which outputs the voltage signal amplified by the amplifying transistor as the pixel signal based on a row select signal outputted from the vertical scan circuit.

According to this configuration, the dummy pixels are constituted by a circuit which includes a transfer transistor, an amplifying transistor, and a row select transistor.

## Claims

1. A solid-state imaging device comprising: a pixel section in which pixels having photoelectric conversion characteristics including linear characteristics and logarithmic characteristics are arranged in a matrix pattern; and a read circuit which reads out a pixel signal from each pixel, wherein
the pixel section includes a normal pixel section made up of normal pixels for exposing a subject and a dummy pixel section made up of dummy pixels having a light-blocked photoelectric conversion element,
the solid-state imaging device further comprising:
a constant current source which injects a constant current to the photoelectric conversion elements of the dummy pixels,
a switches provided between the constant current source and the photoelectric conversion elements of the dummy pixels, and
a tracing unit which traces photoelectric conversion characteristics of the dummy pixels by varying a current value outputted from the constant current sources and obtaining pixel signals outputted from the read circuit,
the tracing unit being configured to turn off the switch at a predetermined read period in which the read circuit reads pixel signals from the dummy pixels.

2. The solid-state imaging device according to claim 1, wherein the dummy pixels are linearly arranged in a predetermined row or a predetermined column in the pixel section.

3. The solid-state imaging device according to claim 1 or 2, wherein one or a plurality of constant current sources are provided in correspondence to each row in which the dummy pixels are arranged.

4. The solid-state imaging device according to claim 1 or 2, wherein
the tracing unit has:
a vertical scan circuit which vertically scans each row of the pixel section; and
a trace control unit which instructs the vertical scan circuit to output the switch signal, and wherein
the vertical scan circuit outputs a switch signal for turning on/off the switch based on an instruction from the trace control unit.

5. The solid-state imaging device according to claim 4, wherein
the dummy pixels have:
a floating diffusion to which an electrical charge accumulated by the photoelectric conversion element is transferred and which generates a voltage signal according to the transferred electrical charge; and
a reset transistor which is turned on/off by a reset signal outputted from the vertical scan circuit and which resets the floating diffusion at a predetermined reset period preceding the read period, and wherein
the vertical scan circuit outputs the reset signal as the switch signal to the switch.

6. The solid-state imaging device according to claim 5, wherein
the dummy pixels have:
a transfer transistor which transfers an electrical charge accumulated at the photoelectric conversion element to the floating diffusion;
an amplifying transistor which amplifies a voltage signal generated by the floating diffusion; and
a row select transistor which outputs the voltage signal amplified by the amplifying transistor as the pixel signal based on a row select signal outputted from the vertical scan circuit.
